# EUROPEAN PATENT SPECIFICATION

(11) **EP 3 588 582 B1**
(45) Date of publication and mention of the grant of the patent: **11.05.2022**
(21) Application number: 17898519.8
(22) Date of filing: 07.06.2017
(51) Int. Cl.: H01L 31/0224, H01L 31/042, H01L 31/18, H01L 31/0352, H01L 31/068

(54) **DRILLING- AND PERC-BASED DOUBLED-SIDED SOLAR CELL, AND ASSEMBLY, SYSTEM, AND MANUFACTURING METHOD THEREOF**
BOHR- UND PERC-BASIERTE DOPPELSEITIGE SOLARZELLE UND MONTAGE, SYSTEM UND HERSTELLUNGSVERFAHREN DAFÜR
CELLULE SOLAIRE BIFACIALE BASÉE PERC ET À PERÇAGE, ET ENSEMBLE, SYSTÈME ET PROCÉDÉ DE FABRICATION DE CELLE-CI

(30) Priority: 03.03.2017 CN 201710122370
(43) Date of publication of application: 01.01.2020
(73) Proprietor: Guangdong Aiko Solar Energy Technology Co., Ltd, Foshan, Guangdong 528000 (CN); Zhejiang Aiko Solar Energy Technology Co., Ltd, Yiwu, Zhejiang 322009 (CN)
(72) Inventor: FANG, Jiebin, Foshan, Guangdong 528000 (CN); HO, Ta-neng, Foshan, Guangdong 528000 (CN); CHEN, Gang, Foshan, Guangdong 528000 (CN)
(74) Representative: Steinbauer, Florian
(86) International application number: PCT/CN2017/087358
(87) International publication number: WO 2018/157495

(56) References cited:
- CN-A- 101 442 085
- CN-A- 103 489 934
- CN-A- 105 702 758
- CN-A- 106 449 876
- CN-U- 204 792 839
- CN-U- 204 792 839
- CN-U- 205 335 274
- CN-U- 206 639 804
- DE-U1-202015 004 065
- JP-A- 2013 098 287
- US-A1- 2008 289 680
- US-A1- 2016 276 499

## Description

### FIELD OF THE INVENTION

The present invention relates to the field of solar cells, and in particular to a bifacial punched PERC solar cell, a method of preparing the bifacial punched PERC solar cell, a solar cell module that employs the bifacial punched PERC solar cell, and a solar system that employs the bifacial punched PERC solar cell.

### BACKGROUND OF THE INVENTION

A crystalline silicon solar cell is a device that effectively absorbs solar radiation energy and converts light energy into electrical energy through the photovoltaic effect. When sunlight reaches the p-n junction of a semiconductor, new electron-hole pairs are generated. Under the action of the electric field of the p-n junction, the holes flow from the N zone to the P zone, and the electrons flow from the P zone to the N zone, generating current upon switching on a circuit.

In a conventional crystalline silicon solar cell, surface passivation is basically only performed at the front surface, which involves depositing a layer of silicon nitride on the front surface of the silicon wafer via PECVD to reduce the recombination rate of the minority carriers at the front surface. As a result, the open-circuit voltage and short-circuit current of the crystalline silicon cell can be greatly increased, which leads to an increase of the photoelectric conversion efficiency of the crystalline silicon solar cell. However, as passivation is not provided at the rear surface of the silicon wafer, the increase in photoelectric conversion efficiency is still limited.

The structure of an existing bifacial solar cell is as follows: the substrate is an N-type silicon wafer; when photons from the sun reach the rear surface of the cell, the carriers generated in the N-type silicon wafer pass through the silicon wafer, which has a thickness of about 200 µm; as in an N-type silicon wafer, the minority carriers have a long lifetime and carrier recombination rate is low, some carriers are able to reach the p-n junction at the front surface; the front surface of the solar cell is the main light-receiving surface, and its conversion efficiency accounts for a high proportion of the conversion efficiency of the whole cell; as a result of overall actions at both the front surface and the rear surface, the conversion efficiency of the cell is significantly increased. However, the price of an N-type silicon wafer is high, and the process of manufacturing a bifacial N-type cell is complicated. Therefore, a hotspot for enterprises and researchers is to how to develop a bifacial solar cell with high efficiency and low cost.

On the other hand, in order to meet the ever-rising requirements for the photoelectric conversion efficiency of crystalline silicon cells, the industry has been researching rear-surface passivation techniques for PERC solar cells. Mainstream manufacturers in the industry are mainly developing monofacial PERC solar cells. The present invention combines a highly efficient PERC cell and a bifacial cell to develop a bifacial PERC solar cell that has overall higher photoelectric conversion efficiency.

Bifacial PERC solar cells have higher usage values in the practical applications as they have high photoelectric conversion efficiency while they absorb solar energy on both sides to generate more power. Thus, the present invention aims to provide a bifacial PERC solar cell which is simple to manufacture, low in cost, easy to popularize, and has a high photoelectric conversion efficiency.

German utility model No. DE 20 2015 004 065 U1 describes an arrangement of several PERC solar cells, wherein the cells are electrically connected by cell connectors, and the rear side of the cells is provided with connecting rails for electrical connection and contacting fingers. The cell connectors are arranged alongside and contacting the connecting rails.

### SUMMARY OF THE INVENTION

An objective to be addressed by the present invention is to provide a bifacial punched PERC solar cell which is simple in structure, low in cost, easy to popularize, and has a significantly high photoelectric conversion efficiency.

Another objective to be addressed by the present invention is to provide a method of preparing the bifacial punched PERC solar cell, which is simple in process, low in cost, easy to popularize, and significantly improves photoelectric conversion efficiency.

Yet another objective to be addressed by the present invention is to provide a bifacial punched PERC solar cell module, which is simple in structure, low in cost, easy to popularize, and has a significantly high photoelectric conversion efficiency.

Still another objective to be addressed by the present invention is to provide a bifacial P-type PERC solar system, which is simple in structure, low in cost, easy to popularize, and has a significantly high photoelectric conversion efficiency.

To address the objectives above, the present invention provides a bifacial punched PERC solar cell, which comprises a rear silver busbar, a rear aluminum finger, a rear passivation layer, a P-type silicon, an N-type emitter, a front passivation layer, a front silver finger, and a front silver busbar; wherein a laser grooving region is formed in the rear passivation layer by laser grooving; the rear aluminum finger line is connected to the P-type silicon via the laser grooving region,
the bifacial PERC solar cell is provided with a light transmitting region penetrating front and rear surfaces of the cell;
the light transmitting region is disposed outside the rear silver busbar and the front silver busbar;
the light transmitting region is disposed on the rear aluminum finger or outside the rear aluminum finger;
the light transmitting region is disposed on the front silver finger or outside the front silver finger, when the light transmitting region is disposed on the front silver finger, the front silver finger includes a first front silver finger and a second front silver finger, the second front silver finger bypasses the light transmitting region and is in contact with the first front silver finger, and wherein
the size of the light transmitting region is smaller than the width of the rear aluminum finger and is greater than the width of the front silver finger.

In a preferred embodiment, the first front silver finger is linear, and the second front silver finger is arc-shaped.

In a preferred embodiment, the light transmitting region is a circular hole, a square hole, a pentagonal hole or a hexagonal hole.

In a preferred embodiment, the number of the light transmitting regions is 2 to 100.

In a preferred embodiment, the size of the light transmitting region is 100 micron to 5 centimeter.

In a preferred embodiment, the width of the rear aluminum finger is 150 micron to 5.5 centimeter and the width of the front silver finger is 30-80 micron.

Accordingly, the present invention also discloses a method of preparing the bifacial punched PERC solar cell, which comprises:
S101: selecting the P-type silicon and performing laser punching to the silicon wafer to form the light transmitting region;
S102: forming textured surfaces at the front and rear surfaces of the silicon wafer;
S103: performing diffusion via the front surface of the silicon wafer to form the N-type emitter;
S104: removing phosphosilicate glass formed during the diffusion;
S105: forming the passivation layers on the front and rear surfaces of the silicon wafer;
S106: performing laser grooving in the rear surface of the silicon wafer;
S107: printing the rear silver busbar on the rear surface of the silicon wafer, wherein the rear silver busbar is printed outside the light transmitting region;
S109: printing the rear aluminum finger on the rear surface of the silicon wafer, wherein the rear aluminum finger is printed surrounding the light transmitting region or outside the light transmitting region;
S110: printing the front silver busbar and the front silver finger on the front surface of the silicon wafer, wherein the front silver busbar is printed outside the light transmitting region;
wherein the front silver finger is printed surrounding the light transmitting region or outside the light transmitting region, when the light transmitting region is provided surrounded by the front silver finger, the front silver finger includes a first front silver finger and a second front silver finger, the second front silver finger bypasses the light transmitting region and is in contact with the first front silver finger;
S111: sintering the silicon wafer at a high temperature to form a rear silver electrode and a front silver electrode;
S112: performing anti-LID annealing on the silicon wafer;
S113: laser-isolating the periphery of the silicon wafer and the periphery of the light transmitting region.

Accordingly, the present invention also discloses a PERC solar cell module, which comprises a PERC solar cell and a packaging material, wherein the PERC solar cell is any one of the bifacial punched PERC solar cells described above.

Accordingly, the present invention also discloses a PERC solar system, which comprises a PERC solar cell, wherein the PERC solar cell is any one of the bifacial punched PERC solar cells described above.

The beneficial effects of the present invention are as follows:

In the present invention, the bifacial PERC solar cell is provided with a light transmitting region penetrating front and rear surfaces of the cell. The light transmitting region, the rear silver busbar, the front silver busbar, the rear aluminum finger and the front silver finger employ special structure designs. Specifically, the light transmitting region is disposed outside the rear silver busbar and the front silver busbar, surrounded by or outside the rear aluminum finger, and surrounded by or outside the front silver finger. If the light transmitting region is disposed surrounded by the front silver finger, the front silver finger includes a first front silver finger and a second front silver finger, the second front silver finger bypasses the light transmitting region and is in contact with the first front silver finger. With the present invention, the sunlight incident on the front surface may be irradiated to the rear surface of the module via the light transmitting region in the cell, and then reflected to the rear surface of the cell by a reflective medium at the rear side of the bifacial solar cell module. As a result, sunlight being back reflected is increased and thereby photoelectric conversion efficiency at the rear side of the cell is significantly improved. Photoelectric conversion efficiency at the rear side of the cell may be improved by 1%-10% (relative value).

### BRIEF DESCRIPTION OF THE DRAWINGS

FIG. 1 is a sectional view of the solar cell of the present invention;
FIG. 2 is a schematic diagram of an embodiment of the rear surface structure of the solar cell of the present invention;
FIG. 3 is a schematic diagram of another embodiment of the rear surface structure of the solar cell of the present invention;
FIG. 4 is a schematic diagram of an embodiment of the front surface structure of the solar cell of the present invention;
FIG. 5 is a schematic diagram of another embodiment of the front surface structure of the solar cell of the present invention.

### DETAILED DESCRIPTION OF THE ILLUSTRATED EMBODIMENTS

To more clearly illustrate the objectives, technical solutions and advantages of the present invention, the present invention will be further described in detail below with reference to the accompanying drawings.

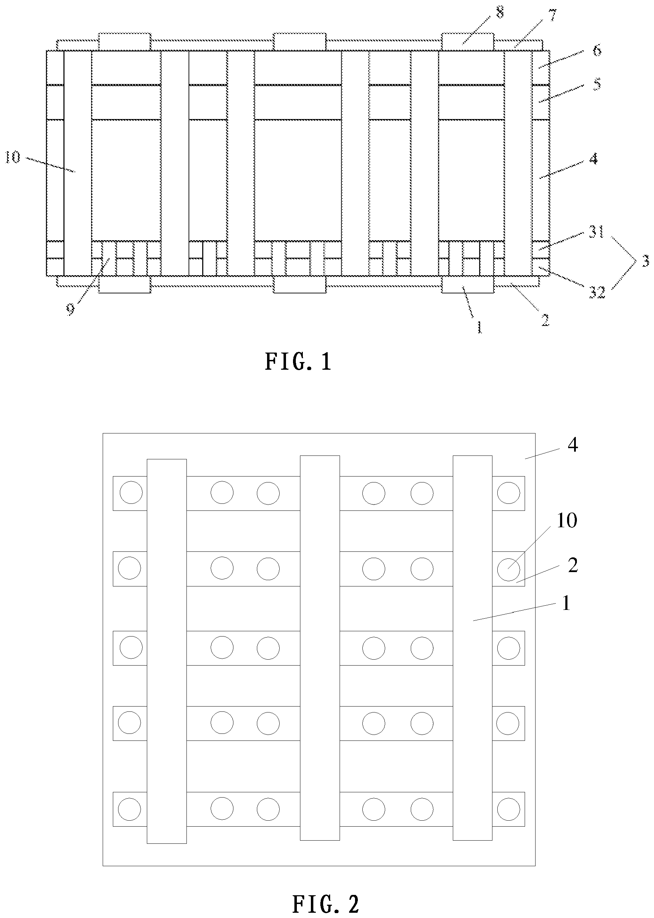

In view of FIGS. 1-5, the present invention provides a bifacial punched PERC solar cell, which comprises a rear silver busbar 1, a rear aluminum finger 2, a rear passivation layer 3, a P-type silicon 4, an N-type emitter 5, a front passivation layer 6, a front silver finger 7, and a front silver busbar 8; wherein a laser grooving region 9 is formed in the rear passivation layer 3 by laser grooving, the rear aluminum finger line is connected to the P-type silicon 4 via the laser grooving region 9.

The bifacial PERC solar cell is provided with a light transmitting region 10 penetrating front and rear surfaces of the cell.

The light transmitting region 10 is disposed outside the rear silver busbar 1 and the front silver busbar 8. The light transmitting region cannot affect the rear silver busbar 1 and the front silver busbar 8, otherwise, soldering when the cell is packaged into a module will be affected.

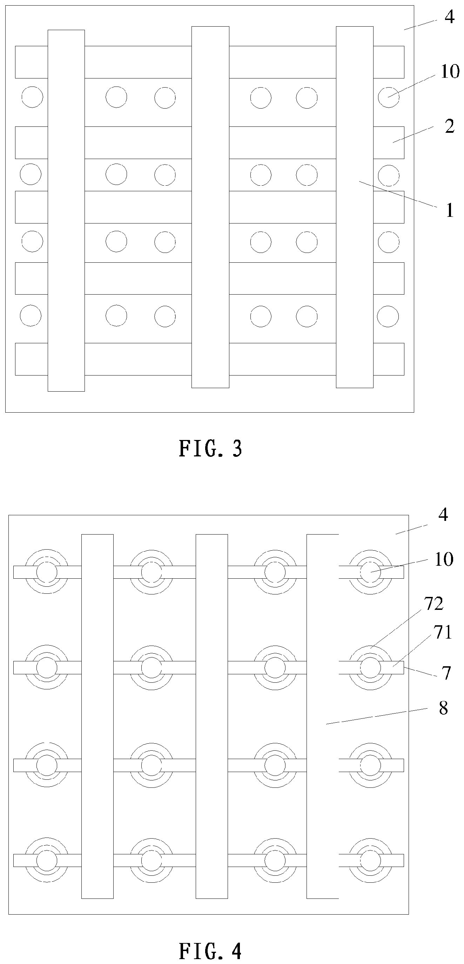

The light transmitting region 10 is disposed on the rear aluminum finger 2 or outside the rear aluminum finger 2. The light transmitting region 10 may have two implementations at the rear surface of the cell, as specifically seen in FIGS. 2-3. As shown in FIG. 2, it shows an embodiment of the rear surface structure of the solar cell, in which the light transmitting region 10 is disposed on the rear aluminum finger 2 and the size of the light transmitting region 10 is smaller than the width of the rear aluminum finger 2. As shown in FIG. 3, it shows another embodiment of the rear surface structure of the solar cell, in which the light transmitting region 10 is disposed outside the rear aluminum finger 2, and the size of the light transmitting region 10 may be greater than the width of the rear aluminum finger 2, or may also be equal to the width of the rear aluminum finger 2, or may further be smaller than the width of the rear aluminum finger 2.

The light transmitting region 10 is disposed on the front silver finger 7 or outside the front silver finger 7. The light transmitting region 10 may have two implementations at the front surface of the cell, as specifically seen in FIGS. 4-5. As shown in FIG. 4, it shows an embodiment of the front surface structure of the solar cell, in which the light transmitting region 10 is disposed on the front silver finger 7, and the size of the light transmitting region 10 is greater than the width of the front silver finger 7. If the light transmitting region 10 is disposed on the front silver finger 7, the front silver finger 7 includes a first front silver finger 71 and a second front silver finger 72. The second front silver finger 72 bypasses the light transmitting region 10 and is in contact with the first front silver finger 71. Preferably, the first front silver finger 71 is linear, and the second front silver finger 72 is arc-shaped.

It should be noted that the first front silver finger 71 may also be in other shapes, such as a wave shape, a zigzag shape, etc., and the second front silver finger 72 may also be in other shapes, such as a curved shape, a triangular shape, a quadrangular shape, a semicircular shape, etc. The embodiments of the first front silver finger 71 and the second front silver finger 72 are not limited to those in the present invention as long as the connection can be achieved.

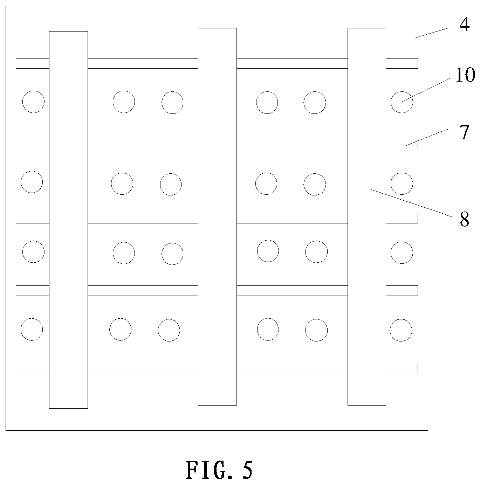

As shown in FIG. 5, it shows another embodiment of the front surface structure of the solar cell, in which the light transmitting region 10 is disposed outside the front silver finger 7 and the size of the light transmitting region 10 may be greater than the width of the front silver finger 7 or may also be equal to the width of the front silver finger 7.

It should be noted that, in the embodiments shown in FIGS. 2-5, the shape, number and size of the light transmitting region 10, the rear silver busbar 1, the rear aluminum finger 2, the front silver finger 7 and the front silver busbar 8 can be defined according to actual needs and the implementation is not limited to the embodiments enumerated in the present invention.

In the present invention, a light transmitting region 10 is provided. The sunlight incident on the front surface may be irradiated to the rear surface of the solar cell module via the light transmitting region of the cell, and then reflected to the rear surface of the solar cell by a reflective medium at the rear surface of the bifacial solar cell module. As a result, sunlight being back reflected is increased and thereby photoelectric conversion efficiency at the rear side of the cell is significantly improved. Photoelectric conversion efficiency at the rear side of the cell may be improved by 1%-10% (relative value). Moreover, in the present invention, the number of the rear silver busbar 1, the rear aluminum finger 2, the front silver finger 7 and the front silver busbar 8 can be reduced by providing the light transmitting region 10, while still being able to achieve the same or even higher photoelectric conversion efficiency, such that the dosage of silver paste and aluminum paste may be effectively reduced. As a result, cost is saved.

Preferably, it is more reasonable in structure design and easier to be implemented in industrialization, if the size of the light transmitting region 10 is smaller than the width of the rear aluminum finger 2 and greater than the width of the front silver finger 7.

Preferably, the light transmitting region 10 is a circular hole, a square hole, a pentagonal hole or a hexagonal hole. More preferably, the light transmitting region 10 is a circular hole or an equilateral polygon hole. It should be noted that the light transmitting region 10 of the present invention can also be in other shapes, such as an octagonal hole, a dodecagonal hole or an irregularly polygonal hole, and the implementation is not limited to the embodiments enumerated in the present invention.

Preferably, the number of the light transmitting regions 10 is 2 to 100, the size of the light transmitting region 10 is 100 micron to 5 centimeter, the width of the rear aluminum finger 2 is 150 micron to 5.5 centimeter and the width of the front silver finger 7 is 30-80 micron. More preferably, the number of the light transmitting regions 10 is 10-50, the size of the light transmitting region 10 is 120 micron to 4 centimeter, the width of the rear aluminum finger 2 is 185 micron to 4.5 centimeter and the width of the front silver finger 7 is 40-70 micron.

Preferably, the rear passivation layer 3 comprises an aluminum oxide layer 31 and a silicon nitride layer 32, the aluminum oxide layer 31 is connected to the P-type silicon 4, and the silicon nitride layer 32 is connected to the aluminum oxide layer 31; the thickness of the silicon nitride layer 32 is 20 to 500 nm; the thickness of the aluminum oxide layer 31 is 2 to 50 nm.

Preferably, the front passivation layer 6 is a front silicon nitride layer.

Accordingly, the present invention also discloses a method of preparing a bifacial punched PERC solar cell, comprising:
S101: selecting the P-type silicon and performing laser punching to the silicon wafer to form a light transmitting region;
S102: forming textured surfaces at a front surface and a rear surface of the silicon wafer;
S103: performing diffusion via the front surface of the silicon wafer to form the N-type emitter;
S104: removing phosphosilicate glass formed during the diffusion;
S105: forming the passivation layers on the front and rear surfaces of the silicon wafer.

The step S105 includes: (A) depositing an aluminum oxide (Al₂O₃) film on the rear surface of the silicon wafer; (B) depositing a silicon nitride film on the rear surface of the silicon wafer; and (C) depositing a silicon nitride film on the front surface of the silicon wafer. It should be noted that the sequence of C with respect to A and B can be interchanged, and C can be performed before A and B.
S106: performing laser grooving in the rear surface of the silicon wafer;
S107: printing the rear silver busbar on the rear surface of the silicon wafer, wherein the rear silver busbar is printed outside the light transmitting region;
S109: printing the rear aluminum finger on the rear surface of the silicon wafer, wherein the rear aluminum finger is printed surrounding the light transmitting region or outside the light transmitting region;
S110: printing the front silver busbar and the front silver finger on the front surface of the silicon wafer, wherein the front silver busbar is printed outside the light transmitting region;
the front silver finger is printed surrounding the light transmitting region or outside the light transmitting region; if the light transmitting region is provided on the front silver finger, the front silver finger includes a first front silver finger and a second front silver finger, the second front silver finger bypasses the light transmitting region and is in contact with the first front silver finger;
S111: sintering the silicon wafer at a high temperature to form a rear silver electrode and a front silver electrode;
S112: performing anti-LID annealing on the silicon wafer;
S113: laser-isolating the periphery of the silicon wafer and the periphery of the light transmitting region.

The preparation method of the present invention further includes performing a polishing treatment on the rear surface of the silicon wafer, which step is performed after the step S104 of removing phosphosilicate glass formed during the diffusion. It should be noted that the polishing treatment on the rear surface may be performed as needed, and the polishing treatment on the rear surface may be subjected or not subjected in the present invention.

Accordingly, the present invention also discloses a PERC solar cell module, which includes a PERC solar cell and a packaging material, wherein the PERC solar cell is any one of the bifacial punched PERC solar cells described above. Specifically, as one embodiment of the PERC solar cell module, it is composed of a high-transmittance tempered glass, a first layer of ethylene-vinyl acetate (EVA) copolymer, a PERC solar cell, a second layer of an ethylene-vinyl acetate (EVA) copolymer, and a backboard which are sequentially connected from top to bottom.

Accordingly, the present invention also discloses a PERC solar system, which includes a PERC solar cell that is any one of the bifacial punched PERC solar cells described above. As a preferred embedment of the PERC solar system, it includes a PERC solar cell, a rechargeable battery pack, a charge and discharge controller, an inverter, an AC power distribution cabinet, and a sun-tracking control system. The PERC solar system therein may be provided with or without a rechargeable battery pack, a charge and discharge controller, and an inverter. Those skilled in the art can adopt different settings according to actual needs.

It should be noted that in the PERC solar cell module and the PERC solar system, components other than the bifacial punched PERC solar cell may be designed with reference to the prior art.

## Claims

1. A bifacial PERC solar cell, comprising a rear silver busbar (1), a rear aluminum finger (2), a rear passivation layer (3), a P-type silicon (4), an N-type emitter (5), a front passivation layer (6), a front silver finger (7), and a front silver busbar (8), wherein a laser grooving region (9) is formed in the rear passivation layer (3) by laser grooving, the rear aluminum finger line is connected to the P-type silicon (4) via the laser grooving region (9), **characterized in that**
the bifacial PERC solar cell is punched and provided with a light transmitting region (10) penetrating front and rear surfaces of the cell;
the light transmitting region (10) is disposed outside the rear silver busbar (1) and the front silver busbar (8);
the light transmitting region (10) is disposed surrounded by the rear aluminum finger (2) or outside the rear aluminum finger (2);
the light transmitting region (10) is disposed surrounded by the front silver finger (7) or outside the front silver finger (7), when the light transmitting region (10) is disposed surrounded by the front silver finger (7), the front silver finger (7) includes a first front silver finger (71) and a second front silver finger (72), the second front silver finger (72) bypasses the light transmitting region (10) and is in contact with the first front silver finger (71);
and wherein the size of the light transmitting region (10) is smaller than the width of the rear aluminum finger line and is greater than the width of the front silver finger line.

2. The bifacial punched PERC solar cell according to Claim 1, whereinthe first front silver finger line is linear and the second front silver finger line is arc-shaped.

3. The bifacial punched PERC solar cell according to Claim 1, wherein the light transmitting region (10) is a circular hole, a square hole, a pentagonal hole or a hexagonal hole.

4. The bifacial punched PERC solar cell according to Claim 1, wherein the number of the light transmitting regions (10) is 2 to 100.

5. The bifacial punched PERC solar cell according to Claim 1, wherein the size of the light transmitting region (10) is 100 micron to 5 centimeter.

6. The bifacial punched PERC solar cell according to Claim 5, wherein the width of the rear aluminum finger line is 150 micron to 5.5 centimeter and the width of the front silver finger line is 30-80 micron.

7. A method of preparing the bifacial punched PERC solar cell according to any one of Claims 1-6, comprising:
S101: selecting the P-type silicon (4) and performing laser punching to the silicon wafer to form the light transmitting region (10);
S102: forming textured surfaces at the front and rear surfaces of the silicon wafer;
S103: performing diffusion via the front surface of the silicon wafer to form the N-type emitter (5);
S104: removing phosphosilicate glass formed during the diffusion;
S105: forming the passivation layers on the front and rear surfaces of the silicon wafer;
S106: performing laser grooving in the rear surface of the silicon wafer;
S107: printing the rear silver busbar (1) on the rear surface of the silicon wafer, wherein the rear silver busbar (1) is printed outside the light transmitting region (10);
S109: printing the rear aluminum finger (2) on the rear surface of the silicon wafer, wherein the rear aluminum finger (2) is printed surrounding the light transmitting region (10) or outside the light transmitting region (10);
S110: printing the front silver busbar (8) and the front silver finger (7) on the front surface of the silicon wafer, wherein the front silver busbar (8) is printed outside the light transmitting region (10);
wherein the front silver finger (7) is printed surrounding the light transmitting region (10) or outside the light transmitting region (10), when the light transmitting region (10) is provided surrounded by the front silver finger (7), the front silver finger (7) includes a first front silver finger (71) and a second front silver finger (72), the second front silver finer bypasses the light transmitting region (10) and is in contact with the first front silver finger (7);
S111: sintering the silicon wafer at a high temperature to form a rear silver electrode and a front silver electrode;
S112: performing anti-LID annealing on the silicon wafer;
S113: laser-isolating the periphery of the silicon wafer and the periphery of the light transmitting region (10).

8. A PERC solar cell module, comprising a PERC solar cell and a packaging material, wherein the PERC solar cell is the bifacial punched PERC solar cell of any one of Claims 1-6.

9. A PERC solar system, comprising a PERC solar cell, wherein the PERC solar cell is the bifacial punched PERC solar cell of any one of Claims 1-6.

## Patentansprüche

1. Bifaziale PERC-Solarzelle, umfassend eine hintere Silbersammelschiene (1), einen hinteren Aluminiumfinger (2), eine hintere Passivierungsschicht (3), ein P-Typ-Silizium (4), einen N-Typ-Emitter (5), eine vordere Passivierungsschicht (6), einen vorderen Silberfinger (7), und eine vordere Silbersammelschiene (8), wobei in der hinteren Passivierungsschicht (3) durch Lasergravur ein Lasergravurbereich (9) ausgebildet ist, die hintere Aluminiumfingerlinie über den Lasergravurbereich (9) mit dem P-Typ-Silizium (4) verbunden ist, **dadurch gekennzeichnet, dass**
die bifaziale PERC-Solarzelle gestanzt und mit einem lichtdurchlässigen Bereich (10) versehen ist, der die Vorder- und Rückseiten der Zelle durchdringt;
der lichtdurchlässige Bereich (10) außerhalb der hinteren Silbersammelschiene (1) und der vorderen Silbersammelschiene (8) angeordnet ist;
der lichtdurchlässige Bereich (10) von dem hinteren Aluminiumfinger (2) umgeben oder außerhalb des hinteren Aluminiumfingers (2) angeordnet ist;
der lichtdurchlässige Bereich (10) von dem vorderen Silberfinger (7) umgeben oder außerhalb des vorderen Silberfingers (7) angeordnet ist, wenn der lichtdurchlässige Bereich (10) von dem vorderen Silberfinger (7) umgeben angeordnet ist, der vordere Silberfinger (7) einen ersten vorderen Silberfinger (71) und einen zweiten vorderen Silberfinger (72) aufweist, wobei der zweite vordere Silberfinger (72) den lichtdurchlässigen Bereich (10) umgeht und in Kontakt mit dem ersten vorderen Silberfinger (71) ist;
und wobei die Größe des lichtdurchlässigen Bereichs (10) kleiner als die Breite der hinteren Aluminiumfingerlinie und größer als die Breite der vorderen Silberfingerlinie ist.

2. Bifazial gestanzte PERC-Solarzelle nach Anspruch 1, wobei die erste vordere Silberfingerlinie linear ist und die zweite vordere Silberfingerlinie bogenförmig ist.

3. Bifazial gestanzte PERC-Solarzelle nach Anspruch 1, wobei der lichtdurchlässige Bereich (10) ein kreisförmiges Loch, ein quadratisches Loch, ein fünfeckiges Loch oder ein sechseckiges Loch ist.

4. Bifazial gestanzte PERC-Solarzelle nach Anspruch 1, wobei die Anzahl der lichtdurchlässigen Bereiche (10) 2 bis 100 beträgt.

5. Bifazial gestanzte PERC-Solarzelle nach Anspruch 1, wobei die Größe des lichtdurchlässigen Bereichs (10) 100 Mikrometer bis 5 Zentimeter beträgt.

6. Bifazial gestanzte PERC-Solarzelle nach Anspruch 5, wobei die Breite der hinteren Aluminiumfingerlinie 150 Mikrometer bis 5,5 Zentimeter und die Breite der vorderen Silberfingerlinie 30-80 Mikrometer beträgt.

7. Verfahren zur Herstellung der bifazial gestanzten PERC-Solarzelle nach einem der Ansprüche 1 - 6, umfassend:
S101: Auswählen des P-Typ-Siliziums (4) und Durchführen des Laser-Stanzens des Siliziumwafers, um den lichtdurchlässigen Bereich (10) zu bilden;
S102: Bilden von texturierten Oberflächen auf der Vorder- und Rückseite des Siliziumwafers;
S103: Durchführen der Diffusion über die vordere Oberfläche des Siliziumwafers, um den N-Typ-Emitter (5) zu bilden;
S104: Entfernen von Phosphorsilikatglas, das sich während der Diffusion gebildet hat;
S105: Bilden der Passivierungsschichten auf der Vorder- und Rückseite des Siliziumwafers;
S106: Durchführen von Lasergravuren auf der Rückseite des Siliziumwafers;
S107: Drucken der hinteren Silbersammelschiene (1) auf die hintere Oberfläche des Siliziumwafers, wobei die hintere Silbersammelschiene (1) außerhalb des lichtdurchlässigen Bereichs (10) gedruckt wird;
S109: Drucken des hinteren Aluminiumfingers (2) auf die hintere Oberfläche des Siliziumwafers, wobei der hintere Aluminiumfinger (2) um den lichtdurchlässigen Bereich (10) herum oder außerhalb des lichtdurchlässigen Bereichs (10) gedruckt wird;
S110: Drucken der vorderen Silbersammelschiene (8) und des vorderen Silberfingers (7) auf die vordere Oberfläche des Siliziumwafers, wobei die vordere Silbersammelschiene (8) außerhalb des lichtdurchlässigen Bereichs (10) gedruckt wird;
wobei der vordere Silberfinger (7) um den lichtdurchlässigen Bereich (10) herum oder außerhalb des lichtdurchlässigen Bereichs (10) gedruckt wird, wobei, wenn der lichtdurchlässige Bereich (10) von dem vorderen Silberfinger (7) umgeben ist, der vordere Silberfinger (7) einen ersten vorderen Silberfinger (71) und einen zweiten vorderen Silberfinger (72) aufweist, wobei der zweite vordere Silberfinger den lichtdurchlässigen Bereich (10) umgeht und in Kontakt mit dem ersten vorderen Silberfinger (7) steht;
S111: Sintern des Siliziumwafers bei hoher Temperatur zur Bildung einer hinteren Silberelektrode und einer vorderen Silberelektrode;
S112: Durchführen eines Anti-LID-Glühens auf dem Silizium-Wafer;
S113: Laser-Isolieren der Peripherie des Silizium-Wafers und der Peripherie des lichtdurchlässigen Bereichs (10).

8. PERC-Solarzellenmodul, umfassend eine PERC-Solarzelle und ein Verpackungsmaterial, wobei die PERC-Solarzelle die bifazial gestanzte PERC-Solarzelle nach einem der Ansprüche 1 bis 6 ist.

9. PERC-Solarsystem, umfassend eine PERC-Solarzelle, wobei die PERC-Solarzelle die bifazial gestanzte PERC-Solarzelle nach einem der Ansprüche 1 bis 6 ist.

## Revendications

1. Cellule solaire PERC bifaciale, comportant une barre-omnibus arrière en argent (1), un doigt arrière en aluminium (2), une couche de passivation arrière (3), un silicium de type P (4), un émetteur de type N (5), une couche de passivation avant (6), un doigt avant en argent (7) et une barre-omnibus avant en argent (8), dans laquelle une zone de striage au laser (9) est formée dans la couche de passivation arrière (3) par striage au laser, la ligne de doigts en aluminium est connectée au silicium de type P (4) via la zone de striage au laser (9), **caractérisée en ce que** la cellule solaire PERC bifaciale est poinçonnée et pourvue d'une zone de transmission de lumière (10) pénétrant dans des surfaces avant et arrière de la cellule ;
la zone de transmission de lumière (10) est disposée à l'extérieur de la barre-omnibus arrière en argent (1) et de la barre-omnibus avant en argent (8) ;
la zone de transmission de lumière (10) est disposée entourée du doigt arrière en aluminium (2) ou à l'extérieur du doigt arrière en aluminium (2) ;
la zone de transmission de lumière (10) est disposée entourée du doigt avant en argent (7) ou à l'extérieur du doigt avant en argent (7), lorsque la zone de transmission de lumière (10) est disposée entourée du doigt avant en argent (7), le doigt avant en argent (7) inclut un premier doigt avant en argent (71) et un second doigt avant en argent (72), le second doigt avant en argent (72) contourne la zone de transmission de lumière (10) et est en contact avec le premier doigt avant en argent (71) ;
et dans laquelle la taille de la zone de transmission de lumière (10) est plus petite que la largeur de la ligne de doigts arrière en aluminium et est plus grande que la largeur de la ligne de doigts avant en argent.

2. Cellule solaire PERC poinçonnée bifaciale selon la revendication 1, dans laquelle la première ligne de doigts avant en argent est linéaire et la seconde ligne de doigts avant en argent est en forme d'arc.

3. Cellule solaire PERC poinçonnée bifaciale selon la revendication 1, dans laquelle la zone de transmission de lumière (10) est un trou circulaire, un trou carré, un trou pentagonal ou un trou hexagonal.

4. Cellule solaire PERC poinçonnée bifaciale selon la revendication 1, dans laquelle le nombre des zones de transmission de lumière (10) est de 2 à 100.

5. Cellule solaire PERC poinçonnée bifaciale selon la revendication 1, dans laquelle la taille de la zone de transmission de lumière (10) est de 100 microns à 5 centimètres.

6. Cellule solaire PERC poinçonnée bifaciale selon la revendication 5, dans laquelle la largeur de la ligne de doigts arrière en aluminium est de 150 microns à 5,5 centimètres et la largeur de la ligne de doigts avant en argent est de 30 à 80 microns.

7. Procédé de préparation de la cellule solaire PERC poinçonnée bifaciale selon l'une quelconque des revendications 1 à 6, comportant les étapes consistant à :
S101 : sélectionner le silicium de type P (4) et réaliser un poinçonnage au laser sur la plaquette de silicium pour former la zone de transmission de lumière (10) ;
S102 : former des surfaces texturées sur les surfaces avant et arrière de la plaquette de silicium ;
S103 : réaliser une diffusion via la surface avant de la plaquette de silicium pour former l'émetteur de type N (5) ;
S104 : retirer du verre phosphosilicaté formé pendant la diffusion ;
S105 : former les couches de passivation sur les surfaces avant et arrière de la plaquette de silicium ;
S106 : réaliser un striage au laser dans la surface arrière de la plaquette de silicium ;
S107 : imprimer la barre-omnibus arrière en argent (1) sur la surface arrière de la plaquette de silicium, dans lequel la barre-omnibus arrière en argent (1) est imprimée à l'extérieur de la zone de transmission de lumière (10) ;
S109 : imprimer le doigt arrière en aluminium (2) sur la surface arrière de la plaquette de silicium, dans lequel le doigt arrière en aluminium (2) est imprimé en entourant la zone de transmission de lumière (10) ou à l'extérieur de la zone de transmission de lumière (10) ;
S110 : imprimer la barre-omnibus avant en argent (8) et le doigt avant en argent (7) sur la surface avant de la plaquette de silicium, dans lequel la barre-omnibus avant en argent (8) est imprimée à l'extérieur de la zone de transmission de lumière (10) ;
dans lequel le doigt avant en argent (7) est imprimé en entourant la zone de transmission de lumière (10) ou à l'extérieur de la zone de transmission de lumière (10),
lorsque la zone de transmission de lumière (10) est disposée entourée du doigt avant en argent (7), le doigt avant en argent (7) inclut un premier doigt avant en argent (71) et un second doigt avant en argent (72), le second doigt avant en argent contourne la zone de transmission de lumière (10) et est en contact avec le premier doigt avant en argent (7) ;
S111 : fritter la plaquette de silicium à une température élevée pour former une électrode arrière en argent et une électrode avant en argent ;
S112 : réaliser un recuit anti-LID sur la plaquette de silicium ;
S113 : isoler au laser la périphérie de la plaquette de silicium et la périphérie de la zone de transmission de lumière (10).

8. Module de cellule solaire PERC, comportant une cellule solaire PERC et un matériau d'encapsulation, dans lequel la cellule solaire PERC est la cellule solaire PERC poinçonnée bifaciale selon l'une quelconque des revendications 1 à 6.

9. Système solaire PERC, comportant une cellule solaire PERC, dans lequel la cellule solaire PERC est la cellule solaire PERC poinçonnée bifaciale selon l'une quelconque des revendications 1 à 6.
